# EUROPEAN PATENT APPLICATION

(11) **EP 4 660 707 A1**
(43) Date of publication of application: **10.12.2025**
(21) Application number: 24179476.7
(22) Date of filing: 03.06.2024
(51) Int. Cl.: G03F 7/16, H01L 21/027

(54) **METHOD OF MANUFACTURING DEVICES BY LITHOGRAPHY WITH RESIST TRANSFER**

(71) Applicant: ASML Netherlands B.V., 5500 AH Veldhoven (NL)
(72) Inventor: KLEIN, Alexander, Ludwig, 5500 AH Veldhoven (NL); KARSSEMEIJER, Leendert, Jan, 5500 AH Veldhoven (NL); ZWIER, Olger, Victor, 5500 AH Veldhoven (NL); ALBU, Diana, Cristina, 5500 AH Veldhoven (NL); KURGANOVA, Evgenia, 5500 AH Veldhoven (NL); OVERKAMP, Jim, Vincent, 5500 AH Veldhoven (NL)
(74) Representative: ASML Netherlands B.V.

(57) **Abstract**

Disclosed is a method of manufacturing devices by lithography, comprising: providing a resist stack on a first substrate, wherein the resist stack comprises a first resist layer, a splitable layer provided on top of the first resist layer and a second resist layer provided on top of the splitable layer; forming a pattern in at least the first resist layer and the second resist layer to obtain a first patterned resist layer and a second patterned resist layer; bonding a second substrate to the second patterned resist layer; and splitting the splitable layer by subjecting it to a splitting mechanism so as to obtain a first patterned device substrate comprising the first substrate and the first patterned resist layer and a second patterned device substrate comprising the second substrate and the second patterned resist layer.

## Description

### FIELD

The present invention relates to a method of manufacturing devices by lithography, in particular to a method that improves the productivity and the energy efficiency of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Such a lithographic apparatus works in conjunction with a projection optics system that has a narrow imaging slot. Rather than expose the entire wafer at one time, individual fields are scanned onto the wafer one at a time. Moving the wafer and reticle simultaneously such that the imaging slot is moved across the field during the scan does this. The wafer stage is then asynchronously stepped between field exposures to allow multiple copies of the reticle pattern to be exposed over the wafer surface. In this manner, the quality of the image projected onto the wafer is maximized.

Conventional lithographic systems and methods form images on a semiconductor wafer. The system typically has a lithographic chamber that is designed to contain an apparatus that performs the process of image formation on the semiconductor wafer. The chamber can be designed to have different grades of vacuum depending on the wavelength of light being used. A reticle is positioned inside the chamber. A beam of light is passed from an illumination source (located outside the system) through an optical system, onto an image outline on the reticle, and a second optical system before interacting with a semiconductor wafer. The reticle may be transmissive or reflective depending on the wavelength of light used; EUV systems for example use a reflective reticle within a vacuum chamber to prevent absorption of the EUV radiation.

The reticle can be placed on a platform or stage (hereinafter, both are referred to as "stage"). The stage can be positioned according to parameters of the lithographic system. Similarly, the semiconductor wafer can be placed on a stage. The stage supporting either the reticle or the semiconductor wafer can be moved one or more directions and/or one or more degrees of freedom depending on how the image is to be formed on the semiconductor wafer.

Energy efficiency of a lithographic system is expressed in kWh per exposed wafer, i.e. kWh/wafer. At present, the energy efficiency of a EUV lithographic system is typically around 4-8 kWh/wafer (e.g., 4-5 kWh/wafer for a low-NA EUV system and 7-8 kWh/wafer for a high-NA EUV system). In contrast, the energy efficiency of a typical DUV (deep ultraviolet) lithographic system is about 0.5 kWh/wafer. Therefore, the energy efficiency of a EUV lithographic system is 10 to 20 times lower than a DUV lithographic system. In view of the world-wide focus on energy savings to reduce the carbon footprint of our society, it is desirable to further improve the energy efficiency of lithographic systems, in particular EUV lithographic systems. One way to improve the energy efficiency of a lithographic system is by increasing the system productivity while keeping energy consumption constant. The method proposed herein is based on this concept.

### SUMMARY

In the first aspect of the invention there is provided a method of manufacturing devices by lithography, comprising: providing a resist stack on a first substrate, wherein the resist stack comprises a first resist layer, a splitable layer provided on top of the first resist layer and a second resist layer provided on top of the splitable layer; forming a pattern in at least the first resist layer and the second resist layer to obtain a first patterned resist layer and a second patterned resist layer; bonding a second substrate to the second patterned resist layer; and splitting the splitable layer by subjecting it to a splitting mechanism so as to obtain a first patterned device substrate comprising the first substrate and the first patterned resist layer and a second patterned device substrate comprising the second substrate and the second patterned resist layer.

In a second aspect of the invention there is provided a patterned substrate or integrated circuit device manufactured by the method of the first aspect.

In a third aspect of the invention there is provided a substrate assembly comprising: a first substrate comprising a resist stack, wherein the resist stack comprises: a first patterned resist layer, a splitable layer provided on top of the first patterned resist layer, and a second patterned resist layer provided on top of the splitable layer.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts schematically the steps of a proposed method of manufacturing devices by lithography, in accordance with an embodiment;
- Figure 3A depicts schematically an example implementation of the proposed splitting mechanism which uses an etching solution to dissolve (thus split) the splitable layer shown in Figure 2;
- Figures 3B depicts schematically another example implementation of the proposed splitting mechanism which uses an etching solution to dissolve (thus split) the splitable layer shown in Figure 2;
- Figure 3C shows a top view of an example of the second substrate shown in Figure 3B; and
- Figure 4 depicts schematically an example process of transferring the second patterned resist layer shown in Figure 2 to a new substrate.

### DETAILED DESCRIPTION

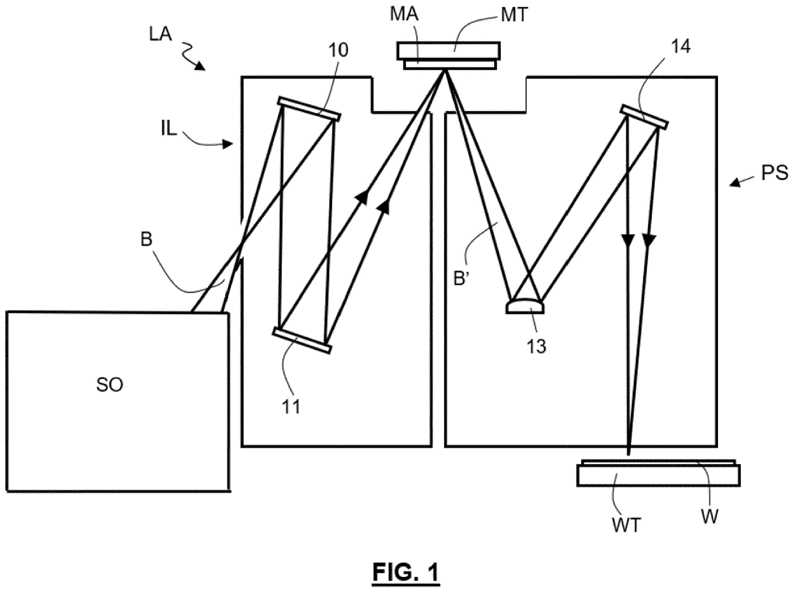

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask or reticle), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In the current lithographic process, each silicon wafer that is coated with a resist layer leaves the lithographic system after a desired pattern for the next process steps has been formed in the resist by projecting a patterned illumination radiation (e.g., EUV radiation) to the wafer. As such, the current lithographic process requires at least one exposure for every wafer that is processed. As mentioned above, one way to improve the energy efficiency of a lithographic system is by increasing the system productivity, which may be achieved by allowing two patterned wafers to be obtained with only a single lithographic exposure. Based on this concept, one aspect of the present disclosure provides a method of manufacturing devices by lithography. The proposed method uses a splitable layer to controllably separate two photosensitive resist layers that have been simultaneously patterned by a single (e.g., EUV) lithographic exposure and as such two patterned wafers can be obtained for every lithographic exposure.

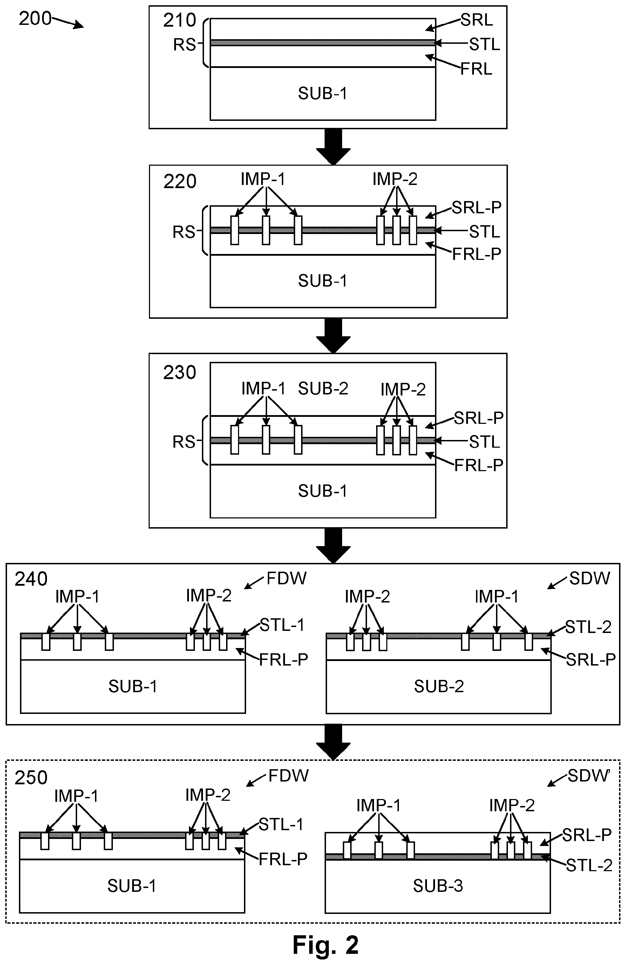

With reference to Figure 2, in an embodiment, the proposed method 200 may comprise the following four main steps 210-240.

The method step 210 comprises providing a resist stack RS on a first substrate SUB-1. The first substrate SUB-1 may be a semiconductor substrate (often referred to as a wafer). The resist stack RS may comprise a first resist layer FRL, a splitable layer STL provided on the top of the first resist layer FRL and a second resist layer SRL provided on the top of the splitable layer STL. The splitable layer STL may be configured to split upon being activated or triggered by a splitting mechanism (see below for more details). In an embodiment, the step of providing the resist stack on the first substrate may comprise depositing one or more layers of the resist stack RS to the first substrate SUB-1. Such layers may be deposited using one or more coating deposition techniques which are commonly used in semiconductor manufacturing, such as for example the spin-on deposition technique. Further information about the spin-on deposition technique and other thin film deposition techniques can be found in the book *"*Handbook of Thin Film Deposition Processes and Techniques" edited by Krishna Seshan, published by Noyes Publications, 2002, ISBN: 0-8155-1442-5, which is incorporated herein by reference.

The method step 220 comprises forming a pattern comprising first features IMP-1 and second features IMP-2 in at least the first resist layer FRL and the second resist layer SRL to obtain a first patterned resist layer FRL-P and a second patterned resist layer SRL-P. In an embodiment, the pattern may be formed simultaneously in at least the first resist layer FRL and the second resist layer SRL. In an embodiment, the forming step may comprise projecting an illumination radiation carrying the pattern to the resist stack RS. In an embodiment, the illumination radiation may comprise an extreme ultraviolet (EUV) radiation. In an embodiment, the forming step may be based on the use of an imprinting method to pattern the resist stack. For example, a stamp may be used to form a pattern in at least the first resist layer FRL and the second resist layer SRL of the resist stack RS. This may be achieved for example using the nanopatterning systems marketed by Molecular Imprints Inc. (which has been acquired by Canon Inc.).

The method step 230 comprises bonding a second substrate SUB-2 to (the top surface of) the second patterned resist layer SRL-P. In an embodiment, the second substrate SUB-2 may be a semiconductor substrate. In an alternative embodiment, the second substrate SUB-2 may be made of a material having certain desired physical properties (e.g., being substantially transparent to ultraviolet (UV) light, see below for more details).

The second substrate SUB-2 may be bonded to the second patterned resist layer SRL-P using existing bonding techniques which are commonly used in semiconductor manufacturing. At present, various bonding techniques have been implemented to bond semiconductor substrates. Among existing bonding techniques, fusion bonding is widely employed for bonding semiconductor substrates. Fusion bonding enables permanent connection via dielectric layers on each bonding semiconductor substrate and provides a good bonding strength with a high bonding yield. Typically, the fusion bonding process comprises three main steps: 1) wafer surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via hydrogen bridge bonds of chemisorbed water molecules which react during the annealing step to form covalent siloxane bonds. Further information about the fusion bonding technique and other wafer bonding techniques can be found in the book *"*Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In some applications, it may be desirable to temporarily bond the second substrate SUB-2 to the second patterned resist layer SRL-P e.g., to allow subsequent transfer of the second patterned resist layer SRL-P from the second substrate SUB-2 to another new substrate (see below for more details). In such cases, existing temporary bonding and debonding techniques may be used. Further information about the temporary bonding and debonding techniques can be found in the scientific publication Zihao Mo, Fangcheng Wang, Jinhui Li, Qiang Liu, Guoping Zhang, Weimin Li, Chunlei Yang and Rong Sun, "Temporary Bonding and Debonding in Advanced Packaging: Recent Progress and Applications", Electronics, 2023, 12, 1666, which is incorporated herein by reference.

The method step 240 comprises splitting the splitable layer STL by subjecting it to a splitting mechanism so as to separate the second substrate SUB-2 along with the second patterned resist layer SRL-P from the first substrate SUB-1 along with the first patterned resist layer FRL-P so as to obtain a first patterned device substrate (or wafer) FDW comprising the first substrate SUB-1 and the first patterned resist layer FRL-P and a second patterned device substrate (or wafer) SDW comprising the second substrate SUB-2 and the second patterned resist layer SRL-P. It will be appreciated that after splitting, the splitable layer STL may be split into a first residual splitable layer STL-1 and a second residual splitable layer STL-2 which are attached to the first patterned resist layer FRL-P and the second patterned resist layer SRL-P, respectively. However, it is also possible that the splitable layer STL may be completed separated from one or both of the first patterned resist layer FRL-P and the second patterned resist layer SRL-P, e.g., as a result of being dissolved by an etching solution (see below for more details). As can be seen in Figure 2 (at step 240), the first features IMP-1 and the second features IMP-2 of the pattern in the second patterned device substrate SDW are in the mirrored positions to the corresponding features of the pattern in the first patterned device substrate FDW. In other words, the pattern in the second patterned device substrate SDW is a mirrored copy of the pattern in the first patterned device substrate FDW.

The splitable layer STL functions to separate the first patterned resist layer FRL-P and the second patterned resist layer SRL-P upon being activated by the splitting mechanism. Therefore, different splitting mechanisms may be applicable to activate the splitting of the splitable layer STL. It will be appreciated that the material of the splitable layer STL may be dependent on the type of the chosen splitting mechanism. Some example implementations will be described in detail below.

In an embodiment, the splitting mechanism may comprise heating the splitable layer STL to a threshold temperature. The heating of the splitable layer STL may trigger the splitable layer STL to undergo a phase transition, e.g., from solid phase to liquid phase. Accordingly, in an embodiment, the splitable layer STL may comprise a layer of material having a melting point equal to or lower than the threshold temperature, said layer of material being configured to melt upon its temperature reaching the threshold temperature. The layer of material may comprise one of, but not limited to, Gallium, Indium or Tin.

Alternatively, or in addition, the heating of the splitable layer STL may cause the splitable layer STL and the first patterned resist layer FRL-P and/or the second patterned resist layer SRL-P to undergo different thermal expansions and thereby result in separation of such layers. Accordingly, in an embodiment, the splitable layer STL may comprise a layer of material having a different coefficient of thermal expansion to that of the first patterned resist layer FRL-P and/or the second patterned resist layer SRL-P. Upon being heated to the threshold temperature, a thermal expansion mismatch between the splitable layer STL and one or both of the first patterned resist layer FRL-P and the second patterned resist layer SRL-P may become sufficiently large to break the adhesion of the splitable layer STL to one or both of the first patterned resist layer FRL-P and the second patterned resist layer SRL-P.

The heating of the splitable layer STL may be achieved in different ways. For example, the heating of the splitable layer STL may be achieved by exposing the whole stack including the first substrate SUB-1, the resist stack RS, and the second substrate SUB-2 to a heat source (e.g., by placing the whole stack into an oven or near a heat gun). Alternatively, the heating of the splitable layer STL may be achieved by running an electrical current through the layer STL. Accordingly, in an embodiment, the splitable layer STL may comprise a layer of material that is electrically conductive.

In an embodiment, the splitable layer STL may comprise a layer (or film) of nanoparticles which may comprise for example single-walled, double-walled or multi-walled carbon nanotubes (CNTs). CNT films are thin but strong and can be made to have low adhesion to other layers (e.g., the first resist layer FRL and the second resist layer SRL). CNT films can be grown in multiple ways such as for example by spin coating of CNT-dispersions or by electron radiation. Once grown, a CNT film may then be applied as the splitable layer STL via a transfer process. Further information about the manufacturing process of large size (up to 300 x 300 mm) free-standing nanoparticle films and their applications in EUV lithography can be found in the scientific publication by Márcio D. Lima, Takahiro Ueda, Luis Plata, Yang Yang, Vincent Le, Nicklas Keller, Chi Huynh, Tetsuo Harada, Takeshi Kondo, "Ultra-low density, nanostructured free-standing films for EUV Pellicles", Proceedings of SPIE, Vol. 11517, 1151709, 2021, which is incorporated herein by reference.

In an embodiment, the splitting mechanism may comprise exposing the splitable layer STL to a radiation to reduce adhesion of the splitable layer STL to one or both of the first patterned resist layer FRL-P and the second patterned resist layer SRL-P. The radiation may cause the splitable layer STL to undergo an amorphous to glass transition which leads to a change in adhesion. In an embodiment, the splitting layer STL may be exposed to a splitting-activation radiation having transmitted through the second substrate SUB-2. In an embodiment, the splitting-activation radiation may comprise a wavelength range at least partially overlapping with the range of for example, between 100 nm and 400 nm, between 200 nm and 400 nm, or between 300 nm and 400 nm. In an embodiment, the second substrate SUB-2 may be substantially transparent to the splitting-activation radiation. The second substrate SUB-2 may be made of sapphire or quartz. In an embodiment, the splitable layer STL may comprise a layer of UV release tape such as for example the UV release film marketed by Force-One Applied Materials CO., ltd. The UV release tape may consist of, but not limited to acrylate polymers, (synthetic) rubber, silicone rubber.

In an embodiment, the splitting mechanism may comprise selectively etching the splitable layer STL. In an embodiment, the splitable layer STL may be selectively etched by applying an etching solution (also known as solvent or developer in semiconductor manufacturing) to the layer. Such an etching solution may only dissolve away the splitable layer STL without affecting the first patterned resist layer FRL-P and the second resist layer SRL-P. The etching solution may comprise for example Toluene, Dichloromethane, Chloroform, Acetone or any other commercially available solvents/developers compatible with the chosen resist.

In an embodiment, the first resist layer FRL may have a first curing dose threshold and the second resist layer SRL may have a second curing dose threshold which may or may not be same as the first curing dose threshold. The splitable layer STL may comprise a layer of resist having a third curing dose threshold. The third curing dose threshold may be higher than the first curing dose threshold and the second curing dose threshold. The exposure dose used in the lithographic apparatus (e.g., an EUV scanner) may be equal to or greater than the first curing dose threshold and the second curing dose threshold but lower than the third curing dose threshold. As such, the exposure to the illumination radiation may only activate or cure the first resist layer FRL and the second resist layer SRL while the splitable layer STL may remain substantially unchanged (or being inactive to the illumination radiation). The splitable layer STL can thus be selectively dissolved by using a suitable solvent. The third curing dose threshold of the splitable layer STL may be for example, at least 100 MJ/cm², at least 150 MJ/cm², or at least 200 MJ/cm². The splitable layer may comprise for example a layer of polymethyl methacrylate (PMMA).

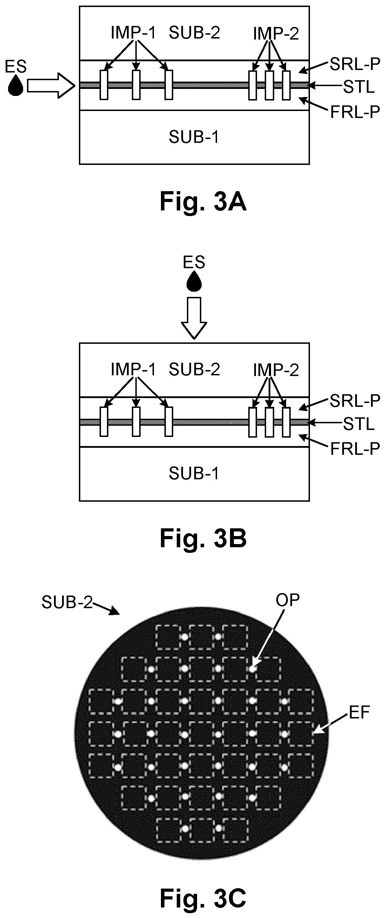

With reference to Figure 3A, in an embodiment, the etching solution may be applied to the splitable layer STL from the side of the resist stack RS. The etching solution may spread across the entire area of the splitable layer STL through the scribe lanes present in the resist stack RS. The scribe lanes are the spacings between e fields in the resist stack RS (e.g., the spacings between dashed squares shown in Figure 3C).

With reference to Figures 3B and 3C, in an embodiment, the second substrate SUB-2 may comprise a plurality of openings OP arranged to direct the etching solution applied from the top of the second substrate SUB-2 to the scribe lanes in the resist stack RS, thereby allowing the applied etching solution to access the first and second patterned layers FRL-P and SRL-P and the splitable layer STL. In an embodiment, the second substrate SUB-2 may be a silicon wafer. The openings in the second substrate SUB-2 may have a diameter ranging from for example 1 µm to 1 mm. In an alternative embodiment, the openings may have a different shape (e.g., a square shape or a rectangular shape) rather than the circular shape shown in Figure 3C. Note that the openings (as indicated by the solid circles) in the second substrate SUB-2 and the exposure fields (as indicated by the dashed lines) are shown not in scale. After the splitable layer STL has been etched, the second patterned resist layer SRL-P may be peeled off from the second substrate SUB-2 and may then be transferred onto a third substrate for further processing (e.g., to obtain final devices). In some cases, depending on the geometry of the patterned layers and that of the openings, the additional peeling-off and transferring steps may not be required.

In an embodiment, the splitting mechanism may comprise applying at least one mechanical force to break the internal bonding of the splitable layer STL. In an embodiment, the splitable layer STL may comprise one or more layers of graphite. A few layers of graphite may still be thin and have low adhesion to each other. The layers of graphite may be applied to a wafer with a transfer process as described above for CNTs or may be grown in-situ on the wafer. The splitable layer STL may split upon applying a first mechanical force to the first substrate SUB-1 and a second mechanical force to the second substrate SUB-2. The first mechanical force and the second mechanical force may be both in the plane of the splitable layer STL and may be along opposite directions. The application of the first mechanical force and the second mechanical force may cause the graphite layers to slide over each other and eventually separate from each other. In an alternative embodiment, the splitable layer STL may comprise two layers of monolayer-graphene and may split in a similar manner as the graphite-based splitable layer STL.

In any of foregoing embodiments, the splitable layer STL may comprise a thickness of for example, between 0 nm and 100 nm, between 0 nm and 90 nm, between 0 nm and 80 nm, between 0 nm and 70 nm, between 0 nm and 60 nm, between 0 nm and 50 nm, between 0 nm and 40 nm, between 0 nm and 30 nm, or between 0 nm and 10 nm.

Referring back to Figure 2, in an embodiment, the proposed method 200 may optionally comprise method step 250 which comprises transferring at least the second patterned resist layer SRL-P of the second patterned device substrate SDW to a third substrate SUB-3 to obtain the second patterned device substrate SDW'. The at least the second patterned resist layer SRL-P may include the second patterned resist layer SRL-P and the second residual splitable layer STL-2. This optional step 250 may require that the second substrate SUB-2 is temporally bonded to the second patterned resist layer SRL-P.

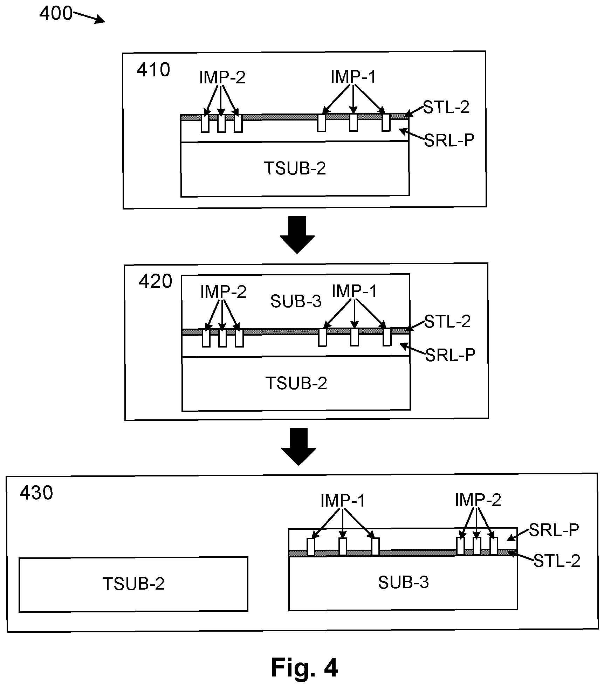

Figure 4 schematically depicts an example method 400 of transferring at least the second patterned resist layer SRL-P from a temporary substrate TSUB-2 to a third substrate SUB-3. The method 400 may comprise the following three method steps 410-430.

Method step 410 comprises providing the second patterned device substrate SDW comprising the second patterned resist layer SRL-P and the second residual splitable layer STL-2. The second patterned resist layer SRL-P is temporarily bonded to the temporary substrate TSUB-2 using an existing temporary bonding technique (e.g., using an adhesive). The second patterned device substrate SDW may be obtained after performing the method step 240 shown in Figure 2. In such a case, the temporary substrate TSUB-2 shown in Figure 4 may correspond to the second substrate SUB-2 shown in Figure 2.

Method step 420 comprises bonding a third substrate SUB-3 to the second residual splitable layer STL-2. The bonding between the third substrate SUB-3 and the second residual splitable layer STL-2 may be achieved using one of the aforementioned bonding methods, such as fusion bonding.

Method 430 comprises separating the temporary substrate TSUB-2 from the second patterned resist layer SRL-P to obtain the second patterned device substrate SDW', which comprises the third substrate SUB-3, the second residual splitable layer STL-2 on the top of the third substrate SUB-3, and the second patterned resist layer SRL-P on the top of the second residual splitable layer STL-2. The separation of the second substrate SUB-2 from the second patterned resist layer SRL-P may be achieved using an existing temporary debonding technique (e.g., the thermal slide debonding method, the mechanical peel-off method, or the laser ablation method).

The above-described transferring method 400 (or the transferring step 250) may bring the second residual splitable layer STL-2 in direct contact with the new substrate (i.e. the third substrate SUB-3). As such, the split resist stack (which may comprise the second patterned resist layer SRL-P and the second residual splitable layer STL-2) may be bonded to the new substrate in an up-side-down manner (see Figure 2 (step 250) or Figure 4). Such an arrangement may be beneficial for defectivity performance of the process and may allow creation of a second patterned device substrate SDW' in which the pattern is oriented in the same manner as the pattern in the first patterned device substrate FDW. However, such a transferring step may not be required in cases where a mirrored version of the first patterned device substrate FDW is preferred.

The first patterned device substrate FDW and the second patterned device substrate SDW or SDW' may be further processed to obtain a plurality of devices. The subsequent processing of the device substrates may be achieved by following the existing process commonly used in semiconductor manufacturing.

Referring back to Figure 2, in some embodiments, the resist stack RS may comprise two or more splitable layers. In such a case, the method steps 210-240 may be repeated multiple times until all the splitable layers are all split. During each repetition of the method steps 210-240, it may be that only one splitable layer may be split upon being activated by a splitting mechanism.

Further embodiments of the invention are disclosed in the list of numbered clauses below:
1. A method of manufacturing devices by lithography, comprising: providing a resist stack on a first substrate, wherein the resist stack comprises a first resist layer, a splitable layer provided on top of the first resist layer and a second resist layer provided on top of the splitable layer; forming a pattern in at least the first resist layer and the second resist layer to obtain a first patterned resist layer and a second patterned resist layer; bonding a second substrate to the second patterned resist layer; and splitting the splitable layer by subjecting it to a splitting mechanism so as to obtain a first patterned device substrate comprising the first substrate and the first patterned resist layer and a second patterned device substrate comprising the second substrate and the second patterned resist layer.
2. A method according to clause 1, wherein the pattern is formed simultaneously in at least the first resist layer and the second resist layer.
3. A method according to clause 1 or 2, wherein the providing step comprises depositing one or more layers of the resist stack to the first substrate.
4. A method according to clause 3, wherein the one or more layers of the resist stack are deposited to the first substrate via spin-on deposition.
5. A method according to any preceding clause, wherein the first substrate comprises a semiconductor substrate.
6. A method according to any preceding clause, wherein the forming step comprises projecting illumination radiation carrying the pattern to the resist stack.
7. A method according to clause 6, wherein the illumination radiation comprises an extreme ultraviolet "EUV" radiation.
8. A method according to any preceding clause, wherein the forming step is based on the use of an imprinting method to pattern the resist stack.
9. A method according to any preceding clause, wherein the splitting mechanism comprises heating the splitable layer to a threshold temperature.
10. A method according to clause 9, wherein the splitable layer comprises a layer of material having a melting point equal to or lower than the threshold temperature, said layer of material being configured to melt upon its temperature reaching the threshold temperature.
11. A method according to clause 10, wherein the layer of material comprises one of Gallium, Indium or Tin.
12. A method according to any of clauses 9 to 11, wherein the splitable layer comprises a layer of material having a coefficient of thermal expansion different to that of the first patterned resist layer and/or the second patterned resist layer such that upon being heated to the threshold temperature, a thermal expansion mismatch between the splitable layer and one or both of the first patterned resist layer and the second patterned resist layer becomes sufficient to break the adhesion of the splitable layer to one or both of the first patterned resist layer and the second patterned resist layer.
13. A method according to any of clauses 10 to 12, wherein the layer of material is electrically conductive, and wherein the heating of the splitable layer is achieved by applying an electrical current through the splitable layer.
14. A method according to clause 13, wherein the layer of material comprises carbon nanotubes.
15. A method according to any preceding clause, wherein the splitting mechanism comprises exposing the splitable layer to a splitting-activation radiation to reduce adhesion of the splitable layer to one or both of the first patterned resist layer and the second patterned resist layer.
16. A method according to clause 15, wherein the splitting layer is exposed to the splitting-activation radiation having transmitted through the second substrate.
17. A method according to clause 16, wherein the splitting-activation radiation comprises a wavelength range at least partially overlapping with the range of between 100 nm and 400 nm.
18. A method according to clause 16 or 17, wherein the second substrate is substantially transparent to the splitting-activation radiation.
19. A method according to clause 18, wherein the second substrate is made of sapphire or quartz.
20. A method according to any of clauses 15 to 19, wherein the splitable layer comprises a layer of ultraviolet "UV" release tape.
21. A method according to any preceding clause, wherein the splitting mechanism comprises selectively etching the splitable layer.
22. A method according to clause 21, wherein the splitable layer is etched by an etching solution.
23. A method according to clause 21 or 22, wherein the splitable layer comprises a layer of resist having a curing dose threshold higher than an exposure dose used in a lithographic apparatus, said exposure dose being equal to or higher than a first curing dose threshold of the first resist layer and a second curing dose threshold of the second resist layer.
24. A method according to clause 23, wherein the third curing dose threshold is at least 100 MJ/cm².
25. A method according to clause 23 or 24, wherein the splitable layer comprises a layer of polymethyl methacrylate (PMMA).
26. A method according to any preceding clause, wherein the splitable layer comprises a thickness of between 0 nm and 100 nm.
27. A method according to any preceding clause, wherein the splitable layer comprises a thickness of between 0 nm and 50 nm.
28. A method according to any preceding clause, further comprising transferring at least the second patterned resist layer of the second patterned device substrate to a third substrate to obtain the second patterned device substrate.
29. A method according to clause 28, further comprising processing the first patterned device substrate and the second patterned device substrate to obtain a plurality of devices.
30. A patterned substrate or integrated circuit device manufactured by the method of any preceding clause.
31. A substrate assembly comprising: a first substrate comprising a resist stack, wherein the resist stack comprises: a first patterned resist layer, a splitable layer provided on top of the first patterned resist layer, and a second patterned resist layer provided on top of the splitable layer.
32. A substrate assembly according to clause 31, wherein said first patterned resist layer and second patterned resist layer comprise a common pattern.
33. A substrate assembly according to clause 31 or 32, wherein the substrate assembly comprises a second substrate bonded to the second patterned resist layer.
34. A substrate assembly according to clause 33, wherein the second substrate is made of sapphire or quartz.
35. A substrate assembly according to any of clauses 31 to 34, wherein the splitable layer comprises a layer of material having a melting point equal to or lower than a threshold temperature, said layer of material being configured to melt upon its temperature reaching the threshold temperature.
36. A substrate assembly according to clause 35, wherein the layer of material comprises one of Gallium, Indium or Tin.
37. A substrate assembly according to any of clauses 31 to 34, wherein the splitable layer comprises a layer of material having a coefficient of thermal expansion different to that of the first patterned resist layer and/or the second patterned resist layer such that upon being heated to a threshold temperature, a thermal expansion mismatch between the splitable layer and one or both of the first patterned resist layer and the second patterned resist layer becomes sufficient to break the adhesion of the splitable layer to one or both of the first patterned resist layer and the second patterned resist layer.
38. A substrate assembly according to clause 37, wherein the layer of material is electrically conductive, and wherein the heating of the splitable layer is achieved by applying an electrical current through the splitable layer.
39. A substrate assembly according to clause 38, wherein the layer of material comprises carbon nanotubes.
40. A substrate assembly according to any of clauses 31 to 34, wherein the splitable layer comprises a layer of UV release tape.
41. A method according to any of clauses 31 to 34, wherein the splitable layer comprises a layer of polymethyl methacrylate (PMMA).
42. A method according to any of clauses 31 to 41, wherein the splitable layer comprises a thickness of between 0 nm and 100 nm.
43. A method according to any of clauses 31 to 42, wherein the splitable layer comprises a thickness of between 0 nm and 50 nm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatuses may be generally referred to as lithographic apparatuses or lithographic tools. Such a lithographic apparatus may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of manufacturing devices by lithography, comprising:
providing a resist stack on a first substrate, wherein the resist stack comprises a first resist layer, a splitable layer provided on top of the first resist layer and a second resist layer provided on top of the splitable layer;
forming a pattern in at least the first resist layer and the second resist layer to obtain a first patterned resist layer and a second patterned resist layer;
bonding a second substrate to the second patterned resist layer; and
splitting the splitable layer by subjecting it to a splitting mechanism so as to obtain a first patterned device substrate comprising the first substrate and the first patterned resist layer and a second patterned device substrate comprising the second substrate and the second patterned resist layer.

2. A method as claimed in claim 1, wherein the forming step comprises projecting illumination radiation carrying the pattern to the resist stack.

3. A method as claimed in claim 2, wherein the illumination radiation comprises extreme ultraviolet "EUV" radiation.

4. A method as claimed in claim 1, wherein the forming step is based on the use of an imprinting method to pattern the resist stack.

5. A method as claimed in any preceding claim, wherein the splitting mechanism comprises heating the splitable layer to a threshold temperature.

6. A method as claimed in claim 5, wherein the splitable layer comprises a layer of material having a melting point equal to or lower than the threshold temperature, said layer of material being configured to melt upon its temperature reaching the threshold temperature.

7. A method as claimed in claim 5 or 6, wherein the splitable layer comprises a layer of material having a coefficient of thermal expansion different to that of the first patterned resist layer and/or the second patterned resist layer such that upon being heated to the threshold temperature, a thermal expansion mismatch between the splitable layer and one or both of the first patterned resist layer and the second patterned resist layer becomes sufficient to break the adhesion of the splitable layer to one or both of the first patterned resist layer and the second patterned resist layer.

8. A method as claimed in claim 5 or 6, wherein the layer of material is electrically conductive, and wherein the heating of the splitable layer is achieved by applying an electrical current through the splitable layer.

9. A method as claimed in claim 8, wherein the layer of material comprises carbon nanotubes.

10. A method as claimed in any of claims 1 to 4, wherein the splitting mechanism comprises exposing the splitable layer to a splitting-activation radiation to reduce adhesion of the splitable layer to one or both of the first patterned resist layer and the second patterned resist layer.

11. A method as claimed in claim 10, wherein the splitting layer is exposed to the splitting-activation radiation having transmitted through the second substrate.

12. A method as claimed in claim 10 or 11, wherein the splitable layer comprises a layer of ultraviolet "UV" release tape.

13. A method as claimed in claim 2, wherein the splitting mechanism comprises selectively etching the splitable layer.

14. A method as claimed in claim 13, wherein the splitable layer comprises a layer of resist having a curing dose threshold higher than an exposure dose used in a lithographic apparatus, said exposure dose being equal to or higher than a first curing dose threshold of the first resist layer and a second curing dose threshold of the second resist layer.

15. A substrate assembly comprising:
a first substrate comprising a resist stack, wherein the resist stack comprises:
a first patterned resist layer,
a splitable layer provided on top of the first patterned resist layer, and
a second patterned resist layer provided on top of the splitable layer.
